(19) **Europäisches Patentamt**
**European Patent Office**
**Office européen des brevets**

(11) **EP 3 985 999 B1**

(12) **EUROPEAN PATENT SPECIFICATION**

(45) Date of publication and mention
of the grant of the patent:
**21.08.2024  Bulletin 2024/34**

(21) Application number: **20202575.5**

(22) Date of filing: **19.10.2020**

(51) International Patent Classification (IPC):
***H04S 7/00*** *(2006.01)*   *H04R 3/00* *(2006.01)*
*H03H 17/00* *(2006.01)*

(52) Cooperative Patent Classification (CPC):
**H04S 7/305;** H03H 2017/009; H04R 3/00;
H04R 2499/13

(54) **METHOD FOR CONFIGURING A DIGITAL AUDIO FILTER, DIGITAL AUDIO FILTER, AND SOUND SYSTEM**

VERFAHREN ZUR KONFIGURATION EINES DIGITALEN AUDIOFILTERS, DIGITALER AUDIOFILTER UND TONSYSTEM

PROCÉDÉ DE CONFIGURATION D'UN FILTRE AUDIO NUMÉRIQUE, FILTRE AUDIO NUMÉRIQUE ET SYSTÈME SONORE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.04.2022  Bulletin 2022/16**

(73) Proprietor: **Alps Alpine Co., Ltd.
Tokyo 145-0067 (JP)**

(72) Inventors:
- **DROUGGE, Per**
 **417 55 Gothenburg (SE)**
- **MOHLIN, Peter**
 **417 55 Gothenburg (SE)**

(74) Representative: **Schmitt-Nilson Schraud Waibel Wohlfrom
Patentanwälte Partnerschaft mbB
Pelkovenstraße 143
80992 München (DE)**

(56) References cited:
 **US-A1- 2005 175 193     US-A1- 2014 153 744**

- **"Passive, active, and digital filters", 23 June 2009, TAYLOR & FRANCIS GROUP, ISBN: 978-1-4200-5885-7, article TANTARATANA SAWASD ET AL: "chapter 19 IIR Filters", pages: 19 - 1, XP055791560**

**Description**

The present invention is in the field of digital filtering of audio signals. In particular, the present invention is in the field of configuring a digital audio filter for a pleasing sound experience.

Modern digital audio filters have become more and more complex. One reason for the increasing complexity is the aim to compensate for the room acoustics in a listening position. Attempts to adapt an audio output to a particular auditory space by compensating for the auditory space artefacts may lead to complex digital audio filters. The complex signal processing may lead to pre-ringing in the audio output, which may again be perceived as disturbing by a listener.

US 2005/0175193 A1 discloses a method for designing a modal equalizer for a low frequency audible range for a predetermined space (listening room) and location (location in the room) therein, in which method modes to be equalized are determined at least by center frequency and decay rate of each mode, creating a discrete-time description of the determined modes, and determining equalizer filter coefficients on the basis of the discrete-time description of the determined modes, and forming the equalizer by means of a digital filter by defining the filter coefficients on the basis of the properties of the modes.

US 2014/0153744 A1 discloses a method and a system to determine an audio precompensation controller for an associated sound generating system including a total of N≧2 loudspeakers, each having a loudspeaker input. The audio precompensation controller has a number L≧1 inputs for L input signals and N outputs for N controller output signals, one to each loudspeaker. For each one of at least a subset of the N loudspeaker inputs, an impulse response is estimated at each measurement position. For each one of the L input signal(s), a selected one of the N loudspeakers is specified as a primary loudspeaker and a selected subset S including at least one of the N loudspeakers as support loudspeaker(s).

It would be beneficial to provide a method for configuring a digital audio filter that allows for complex signal processing, while also allowing to handle pre-ringing. It would also be beneficial to provide a digital audio filter having such configuration.

Exemplary embodiments of the invention include a method for configuring a digital audio filter in accordance with claim 1 and a vehicle sound system in accordance with claim 12. Further embodiments of the invention are given in the dependent claims.

Exemplary embodiments of the invention include a method for configuring a digital audio filter, comprising: determining the poles of an initial transfer function of the digital audio filter in the z-domain, with the initial transfer function comprising a target function component and a compensation function component; selecting at least one subset of the poles of the transfer function that are outside the unit circle; for each of the at least one subset of the poles of the transfer function that are outside the unit circle: determining a subset-specific partial transfer function, determining a subset-specific, frequency-dependent phase response of the subset-specific partial transfer function, and determining a subset-specific phase modification component, with the subset-specific phase modification component being dependent on the subset-specific, frequency-dependent phase response of the subset-specific partial transfer function; and providing a modified transfer function, comprising the target function component, the compensation function component, and at least one subset-specific phase modification component.

Exemplary embodiments of the invention allow for reducing pre-ringing, introduced by a compensation function component, in a targeted manner. In this way, pre-ringing may be counteracted with high effectiveness and low invasiveness. By specifically addressing one or more poles of the initial transfer function outside of the unit circle, undesired pre-ringing of the compensation function component can be altered in a targeted manner. It has been found that providing a phase modification component that is dependent on a phase response, associated with one or more poles outside the unit circle, may provide a very effective way of reducing pre-ringing, while being little invasive regarding the perceived sound quality and having little or even no effect on the magnitude of the frequency response.

The initial transfer function comprises a target function component and a compensation function component. The target function component may depend on the intended use of the digital audio filter. For example, the target function component may be an amplification function component or an equalizing function component or a bandpass function component or any other desired function component. The compensation function component may be a function component that counteracts the artefacts of a particular auditory space. For example, the compensation function component may be the inverse of a transfer function of a particular auditory space or the inverse of an approximation of the transfer function of a particular auditory space or similar component. The transfer function of a particular auditory space may be determined by recording a response of the auditory space to a known audio output or by a sine sweep or by any other suitable methodology.

The method comprises selecting at least one subset of the poles of the transfer function that are outside the unit circle. The term subset may refer to any number of the poles of the transfer function that are outside the unit circle. In particular, the subset may comprise one, two, three, four, five, six, seven, eight, nine, ten or more poles outside the unit circle. The subset may also comprise all poles of the transfer function that are outside the unit circle.

The method comprises determining a subset-specific partial transfer function. The term subset-specific partial transfer function refers to that part of the initial transfer function that is determined by the given subset of poles outside the unit circle. In other words, the given subset of poles outside the unit circle defines a subset-specific partial transfer function, whose transfer characteristics are set by the given subset of poles outside the unit circle. One of the transfer characteristics is the subset-specific, frequency-dependent phase response.

The method comprises providing a modified transfer function, comprising the target function component, the compensation function component, and at least one subset-specific phase modification component. In this method step, the term at least one subset-specific phase modification component reflects the fact that one or more, i.e. at least one, subset(s) of the poles of the transfer function outside the unit circle are addressed and that, accordingly, one or more subset-specific phase modification component(s) are provided. The step of providing the modified transfer function may include incorporating all of the subset-specific phase modification components, which have been determined when addressing the subsets of the poles outside the unit circle, into the modified transfer function. The phase modification components may be viewed as parts of a modified target function component or as parts of a modified compensation function component or as separate components of the modified transfer function.

According to a further embodiment, each of said at least one subset of the poles outside the unit circle comprises one or two or more poles outside the unit circle.

According to a further embodiment, the subset-specific phase modification component comprises a modification term of the form $\exp(i * k_n * f_n(\theta_n(\omega)))$, wherein $\theta_n(\omega)$ is the subset-specific, frequency-dependent phase response. In this way, a direct and highly effective moving of the poles of the given subset of poles may be achieved, with the factor $k_n$ allowing for the parametrization of an extent of modification of the transfer function / an extent of moving of the poles of the subset of poles. With the factor $k_n$, moving undesired pre-ringing to less disturbing post-ringing may be achieved in an effective and flexible manner. The expressions $k_n$, $\theta_n(\omega)$, and $f_n(\theta_n(\omega))$ refer to the n-th subset of the poles outside the unit circle. If N subsets of poles outside the unit circle are addressed in the method, n may be a running variable running from 1 to N.

According to a further embodiment, $f_n(\theta_n(\omega))$ is $\theta_n(\omega)$. In other words, the function $f_n$ has no effect on $\theta_n(\omega)$. In yet other words, the function $f_n$ may be viewed as a frequency-independent factor of 1. In this way, the subset-specific, frequency-dependent phase response $\theta_n(\omega)$ is directly part of the exponential modification term, which is then of the form $\exp(i * k_n * \theta_n(\omega))$.

According to a further embodiment, $f_n(\theta_n(\omega))$ is a windowed version of $\theta_n(\omega)$. The function $f_n(\theta_n(\omega))$ may weigh different phase shift values along the frequency axis differently and/or may clip one or more portions of the phase response. In this way, an additional degree of freedom may be provided for realising effective phase modification components. The additional degree of freedom may be used for focussing on particularly disturbing frequency components and/or for keeping the subset-specific phase modification component at a well-manageable level and/or for achieving other design goals. While a windowing function is described as a potential implementation of $f_n(\theta_n(\omega))$, $f_n(\theta_n(\omega))$ may be any kind of function that is suitable for being applied to the subset-specific, frequency-dependent phase response $\theta_n(\omega)$ and for yielding a suitable subset-specific phase modification component.

According to a further embodiment, $k_n$ is larger than 0. In particular, $k_n$ may be larger than 0 and smaller or equal to 2. Further in particular, $k_n$ may be between 1 and 2. With the given value ranges, an effective balancing between pre-ringing and post-ringing may be achieved. With $k_n$ being between 1 and 2, a particularly effective amount of pre-ringing may be moved to post-ringing, contributing to a particularly good listening experience.

According to a further embodiment, the method further comprises setting $k_n$ on the basis of a user input and/or setting $k_n$ on the basis of a configuration file and/ or setting $k_n$ on the basis of a parametrization function. With $k_n$ being based on a user input, a very high degree of flexibility in configuring the subset-specific phase modification component may be achieved. When setting $k_n$ on the basis of a parametrization function, additional information, further to the pole(s) of the subset in question being outside the unit circle, may be taken into account. For example, the parametrization function may set $k_n$ depending on how far outside the unit circle and/or where outside the unit circle the pole(s) is/are.

According to a further embodiment, the subset-specific phase modification component has a purely phase-modifying effect. In this way, the subset-specific phase modification component may have no effect on the magnitude of the frequency response of the transfer function, i.e. the magnitude of the frequency response of the transfer function may remain unaltered.

According to a further embodiment, said at least one subset of the poles of the transfer function that are outside the unit circle comprises a plurality of subsets of the poles of the transfer function that are outside the unit circle. The additional features, processing steps, and effects, as described above with respect to the at least one subset of the poles outside the unit circle, may be applied to addressing the plurality of subsets of the poles outside the unit circle in an analogous manner. In this way, more than one subset of the poles outside the unit circle may be addressed in above-described manner, and undesired pre-ringing that is associated with different subsets of poles outside the unit circle may be controlled in a subset-selective manner. Each of the plurality of subsets of the poles outside the unit circle may comprise one, two, three, four, five, six, seven, eight, nine, ten or more poles outside the unit circle. The total number of poles outside the unit circle may comprise one or more complex conjugate pole pairs. The subsets of poles outside the unit circle may comprise or consist of complex conjugate pole pairs. The plurality of subsets of the poles may jointly comprise the full set of poles of the initial transfer function outside the unit circle. It is also possible that the plurality of subsets of the poles do not jointly cover the full set of poles of the initial transfer function outside the unit circle. By being able to address all or only a selection of the poles outside the unit circle, the method may flexibly handle undesired pre-ringing and may allow for an optimized compromise between handling pre-ringing, having a little invasive effect on the audio signal, and having little added complexity.

According to a further embodiment, for at least a first subset of the poles that are outside the unit circle and a second subset of the poles that are outside the unit circle, the dependencies of a first phase modification component, associated with the first subset, and a second phase modification component, associated with the second subset, on a first subset-specific, frequency-dependent phase response, associated with the first subset, and a second subset-specific, frequency-dependent phase response, associated with the second subset, differ from each other. In this way, individual poles or individual complex conjugate pole pairs or other subsets of poles may be addressed with different phase modification components, and their pre-ringing may be controlled in an individual manner. A highly targeted and highly effective control of pre-ringing may be achieved, and the transfer function may be modified in a selective manner, focusing on a selective reduction of pre-ringing and, thus, a selective improvement of sound quality. It is possible that the phase modification components differ from each other for all of the plurality of subsets of poles outside the unit circle. However, it is also possible that some of the subsets of poles are addressed in the same manner. For example, it is possible to provide similar or equal dependencies of the subset-specific phase modification components on the subset-specific, frequency-dependent phase responses for closely related poles and/or for poles that have similar impacts on the pre-ringing characteristics of the transfer function.

According to a further embodiment, for the plurality of subsets of the poles of the transfer function that are outside the unit circle, each subset-specific phase modification component comprises a respective modification term of the form $\exp(i * k_n * f_n(\theta_n(\omega)))$, wherein $\theta_n(\omega)$ is the respective subset-specific, frequency-dependent phase response. The considerations with respect to $k_n$, $\theta_n(\omega)$, and $f_n(\theta_n(\omega))$, as given above in the context of at least one subset of poles outside the unit circle, apply to the plurality of subsets of poles outside the unit circle in an analogous manner.

According to a further embodiment, for at least two of the plurality of subsets of the poles of the transfer function that are outside the unit circle, the $k_n$ differ from each other. Again, if N subsets of poles outside the unit circle are addressed in the method, n may be a running variable running from 1 to N. All of the $k_n$ may differ from each other. It is also possible that some of the $k_n$ are equal to each other. With different numbers of subsets of poles outside the unit circle potentially being addressed, it is understood that two different factors or more than two different factors or many different factors may be used. With the $k_n$ being available for parametrization of the phase modification components, a direct and not so complex way of adapting the phase modification components is provided.

According to a further embodiment, the method further comprises: providing a finite impulse response (FIR) filter implementation in the time domain or a block-based filter implementation in the frequency domain in accordance with the modified transfer function. The providing of the FIR filter may in particular comprise setting the length and the parameters of the FIR filter. In this way, a ready to use configuration for the digital audio filter may be provided. It is pointed out that other types of implementations of the digital audio filter are possible as well. In particular, any kind of filter architecture that is suitable for providing an implementation of the modified transfer function or an implementation of an approximation of the modified transfer function may be employed.

Also disclosed herein is a digital audio filter, configured in accordance with the method for configuring a digital audio filter, as described in any of the embodiments above. The additional features, modifications and effects, as discussed above with respect to a method for configuring a digital audio filter, apply to the digital audio filter in an analogous manner. In particular, the digital audio filter may provide for a particularly pleasing listening experience, as undesired pre-ringing may be effectively controlled by the digital audio filter, before the audio signal is output to the auditory space.

Exemplary embodiments of the invention further include a sound system, comprising a digital audio filter as described above. The additional features, modifications and effects, as described above with respect to the method for configuring a digital audio filter and with respect to the digital audio filter, apply to the sound system in an analogous manner. The sound system may comprise further components. In particular, the sound system may comprise an audio source and one or more speakers, in particular one or more active speakers. In a particular embodiment, the sound system may comprise two, three, four, five, six, seven or more speakers. Besides the digital audio filter, the audio source, and the speaker(s), the sound system may comprise further audio filters. The audio source may be coupled to the digital audio filter described herein, either directly or indirectly, and the digital audio filter described herein may be coupled to the speaker(s), either directly or indirectly.

The sound system is a vehicle sound system. In particular, the sound system may be a car sound system. The effects, as described herein, may be particularly useful in the car environment, because a car interior is a very complex auditory space and there is a lot of room for enhancing the listening experience for the driver and/or the passenger(s) in the car.

For the vehicle sound system, the compensation function component represents a compensation for auditory space artefacts of a vehicle interior. A vehicle interior has a complex geometry for a sound system, inter alia due to the fixed positions for the speakers, the fixed listening position(s), the small size of the auditory space, the sound-reflecting windows, etc. In order to counteract these artefacts, complex compensation function components may be employed. Due to their non-minimum phase property, such complex compensation function components may introduce undesired pre-ringing. Above described control of pre-ringing by addressing poles outside the unit circle may have a particularly large effect on the listening experience in the vehicle interior.

Exemplary embodiments of the invention further include a method for outputting audio content into a vehicle interior, the method comprising: filtering a digital audio signal with a digital audio filter, as described in any of the embodiments above; and outputting audio content, based on the filtered digital audio signal, via speakers arranged in the vehicle interior. The additional features, modifications, and effects, as described above with respect to the method for configuring a digital audio filter, the digital audio filter, and the sound system, apply to the method for outputting audio content into the vehicle interior in an analogous manner.

Further exemplary embodiments of the invention are described with respect to the accompanying drawings, wherein:

Fig. 1 shows a sound system in accordance with an exemplary embodiment of the invention in a block diagram;

Fig. 2 shows a car in a cut-open top view, the car being equipped with the sound system of Fig. 1;

Fig. 3 shows a flow diagram for a method for configuring a digital audio filter in accordance with an exemplary embodiment of the invention;

Fig. 4 illustrates the effect of the method for configuring a digital audio filter of Fig. 3 via illustrating the effect on poles of the initial transfer function in the z-domain.

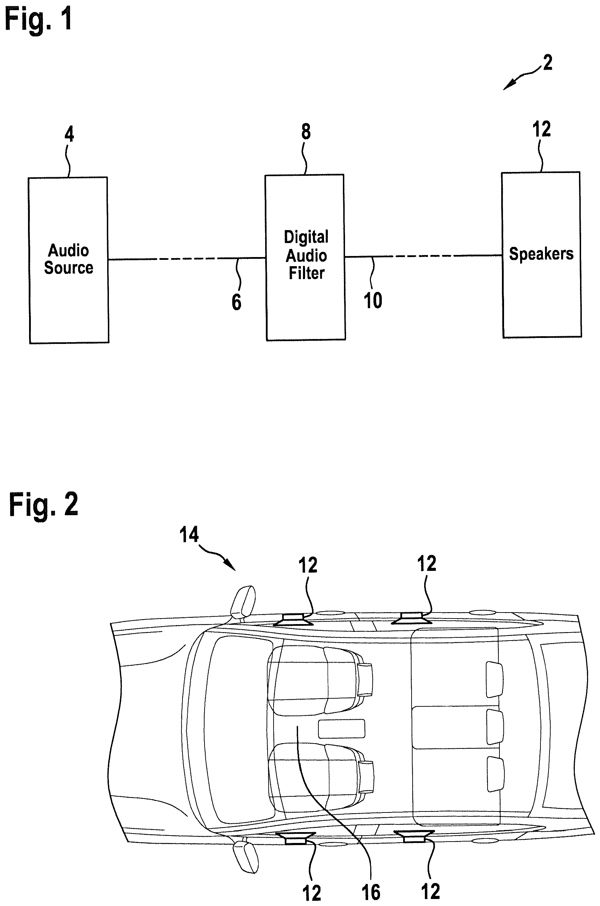

Fig. 1 shows a sound system 2 in accordance with an exemplary embodiment of the invention in a block diagram. In the exemplary embodiment of Fig. 1, the sound system 2 is a car sound system. However, it is pointed out that the sound system 2 may also be a sound system configured for a different application.

The sound system 2 comprises an audio source 4, a digital audio filter 8 in accordance with an exemplary embodiment of the invention, and a plurality of active speakers 12. The audio source 4 is coupled to the digital audio filter 8. In particular, the output of the audio source 4 may result in a filter input 6 to the digital audio filter 8. The dashed line between the audio source 4 and the digital audio filter 8 in Fig. 1 indicates that additional signal processing may take place between the audio source 4 and the digital audio filter 8. In particular, one or more additional filters may be provided between the audio source 4 and the digital audio filter 8. The digital audio filter 8 transforms the filter input 6 into a filter output 10. The digital audio filter 8 is coupled to the speakers 12. In operation, the speakers 12 output audio content, resulting from the signal output 10 of the digital audio filter 8. The dashed line between the digital audio filter 8 and the speakers 12 indicates that additional signal processing may take place between the digital audio filter 8 and the speakers 12. In particular, one or more additional filters may be provided between the digital audio filter 8 and the speakers 12.

In the illustration of Fig. 1, a single signal line is depicted between the audio source 4 and the audio filter 8, and a single signal line is depicted between the digital audio filter 8 and the speakers 12. It is understood that the audio signals may be one-channel audio signals or multi-channel audio signals, such as two-channel or three-channel or four-channel or five-channel or six-channel or seven-channel audio signals. The digital audio filter 8 may perform signal processing on individual channels or on subsets of channels or on all channels of the audio signal. The signal processing of the individual channels may be independent from each other. However, it is also possible that the signal processing in the digital audio filter 8 contains dependencies between the channels.

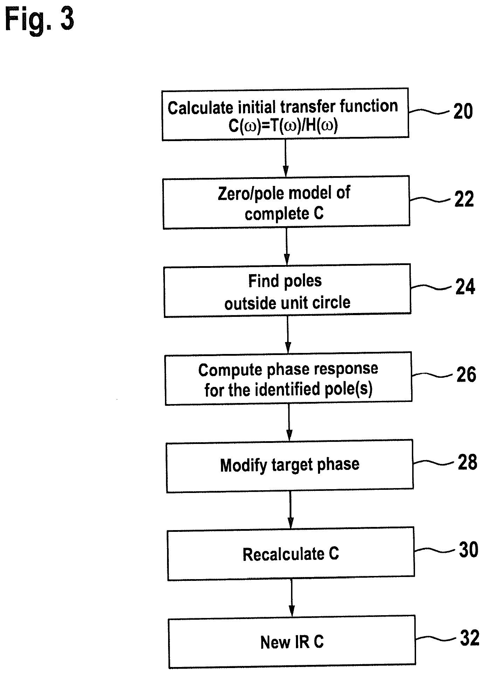

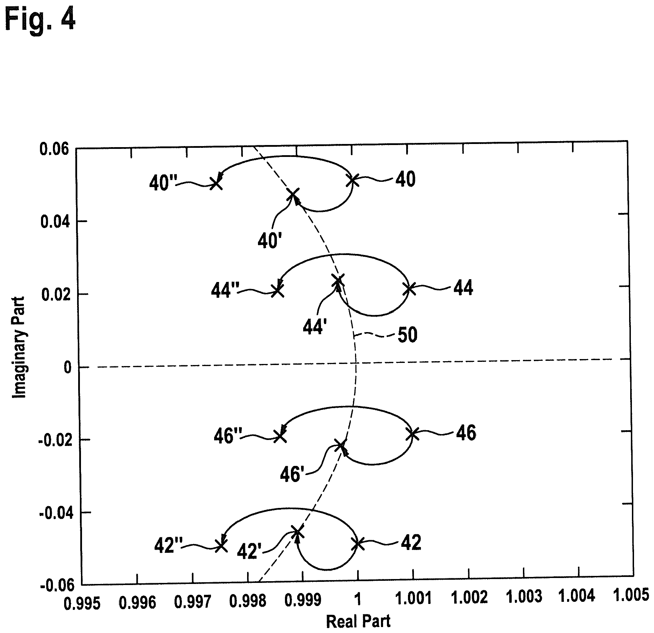

The digital audio filter 8 is configured in accordance with an exemplary embodiment of the invention. This means that the digital audio filter 8 is configured in accordance with any of the methods for configuring a digital audio filter, as described above and/or as will be described below with respect to Figs. 3 and 4.

Fig. 2 shows a car 14 that is equipped with a sound system in accordance with an exemplary embodiment of the invention in a cut-open top view. In the exemplary embodiment of Fig. 2, the sound system is the exemplary sound system 2 of Fig. 1. For ease of illustration, only the speakers 12 of the sound system are depicted in Fig. 2. It is understood that the other components of the sound system 2, in particular the audio source 4 and the digital audio filter 8, as shown in and described with respect to Fig. 1, are also arranged in the car 14. For example, they may be arranged in a dashboard portion of the car 14 and may be coupled to the speakers 12 via according audio lines. Being part of and being configured for the car 14, the sound system is also referred to as a car sound system.

The speakers 12 are arranged in such a way that they output the audio content into a vehicle interior 16 of the car 14. In the exemplary embodiment of Fig. 2, there are four speakers 12, which are arranged in the left front door, the right front door, the left rear door, and the right rear door. It is understood that other numbers of speakers and other arrangements in the vehicle interior 16 are possible as well.

The sound system of the car 14 is adapted to the particular auditory space of the vehicle interior 16. In other words, the sound system is adapted to the auditory space artefacts that are introduced by the particular layout of the vehicle interior 16. The auditory space artefacts may be caused by the relative positions of the speakers and the listener(s), the small size of the auditory space, the sound-reflecting windows, etc. It will be described below with respect to Figs. 3 and 4 how the sound system, in particular the digital audio filter thereof, is adapted to the particular auditory space.

Fig. 3 shows a flow diagram of a method for configuring a digital audio filter in accordance with an exemplary embodiment of the invention. The method starts at step 20 with the provision of the initial transfer function $C(\omega)$. Step 20 is also referred to as the step of calculating the initial transfer function, because a target function component $T(\omega)$ and a compensation function component $1/H(w)$ are brought together in step 20 in the exemplary embodiment of Fig. 3. It is pointed out that the initial transfer function $C(\omega)$ may also be calculated, before the depicted method starts. The initial transfer function $C(w)$ may be readily available at the start of the method.

The target function component $T(w)$ may be any desired transfer characteristic of the digital audio filter, herein referred to also as target function $T(w)$. In the case of the digital audio filter being an amplifier, the target function component $T(w)$ may be a simple natural factor. However, the target function component $T(\omega)$ may also be of a more complex form, depending on the purpose of the digital audio filter. For example, in case the digital audio filter is an equalizer, a more complex target function component $T(\omega)$, representing the desired equalizing function, may be provided. Providing target characteristics of the digital audio filter and expressing them in a frequency-dependent form as a target function component $T(w)$ is well-known in the art.

In the exemplary embodiment of Fig. 3, the compensation function component $1/H(w)$ represents a compensation for the auditory space artefacts of a given auditory space. For example, the compensation function component $1/H(\omega)$ may be the inverse of a frequency response $H(\omega)$ that represents the auditory space artefacts of the given auditory space. Looking at the sound system 2 of Fig. 1 and the vehicle interior 16 of Fig. 2 as the auditory space, the compensation function component $1/H(\omega)$ may be the inverse of the auditory space artefacts introduced by the vehicle interior 16.

In the exemplary embodiment of Fig. 3, the initial transfer function, written in frequency-dependent form, is $C(\omega)$ = $T(w)/H(w)$. It is pointed out that the initial transfer function may also be provided in a different form. For example, the initial transfer function may be readily provided in the z-domain, i.e. the initial transfer function may be represented in the form $C(z) = T(z)/H(z)$.

At step 22, a zero-pole-representation of the initial transfer function $C(w)$ is provided. The zero-pole representation of the initial transfer function may in particular be provided in the z-domain and may be expressed as:

$$C(z) = K \frac{(z-z_1)(z-z_2)\cdots(z-z_l)}{(z-p_1)(z-p_2)\cdots(z-p_m)} .$$

According to the general writing of the foregoing formula, the initial transfer function C has l zeros and m poles. The m poles of the initial transfer function may be the m poles of the transfer function component $1/H$. In that case, the m poles may also be viewed as the m zeros of the function H that represents the auditory space artefacts of the given auditory space.

At step 24, it is determined if and which ones of the m poles are outside the unit circle. On the basis of the zero-pole-representation, as provided at step 22, the poles outside the unit circle may be immediately derived. It is pointed out that the poles outside the unit circle may also be determined from the initial transfer function in any other suitable manner. Stated in a generalized manner, step 24 of the exemplary method of Fig. 3 determines those p poles that are outside the unit circle, with $0 \le p \le m$. In other words, a portion of the total number of poles is determined in step 24 to be outside the unit circle, wherein the portion may be an empty set or a full set of the m poles or any subset of the m poles. When generally referring to one of the poles outside the unit circle, the variable j may be used, with j running from 1 to p.

The p poles outside the unit circle are associated with pre-ringing in the impulse response corresponding to the initial transfer function. It will be laid out in the following how these poles may be addressed to alter / mitigate the pre-ringing in the initial transfer function, in particular the pre-ringing caused by the compensation function component.

At step 26, at least one subset of the p poles that are outside the unit circle is selected. An exemplary subset n may consist of two poles, which are a complex conjugate pole pair. The poles of said exemplary subset n may be the j-th pole and the (j+1)-th pole of the poles outside the unit circle. While said exemplary subset n, having two poles, is looked at for illustrative purposes, it is stressed that one or more subsets of the poles outside the unit circle may be selected and that the one or more subsets may have one or two or more poles, respectively.

For said exemplary subset n, a subset-specific partial transfer function is determined. Said subset-specific partial transfer function may be expressed as follows:

$$C_n(z) = \frac{1}{(z - p_j)(z - p_{j+1})}.$$

From said subset-specific partial transfer function, a subset-specific, frequency-dependent phase response is determined. The subset-specific, frequency-dependent phase response is a frequency-dependent function, representing the phase shift, associated with the partial transfer function, versus the frequency. The subset-specific, frequency-dependent phase response is expressed herein as $\theta n(\omega)$.

It is again stressed that for N subsets of poles outside the unit circle, N subset-specific partial transfer functions and N subset-specific frequency-dependent phase responses may be determined in step 26. The N subsets may address the full set of the p poles outside the unit circle or a portion thereof.

At step 28, the target phase of the transfer function is modified. In particular, for each of the subsets of poles outside the unit circle, as selected in step 26, a subset-specific, frequency-dependent phase modification component is determined. In the exemplary embodiment of Fig. 3, the respective phase modification components have the form (exp(i * kn * $\theta n(\omega)$)), with n being a running variable, running from 1 to the number of selected subsets N, and with $\theta n(\omega)$ being the subset-specific, frequency-dependent phase response of the n-th subset of selected poles. In the exemplary embodiment of Fig. 3, all of kn are chosen to be between 1 and 2. In this way, the pre-ringing associated with the respective subsets of poles outside the unit circle, as selected in step 26, is adjusted to be at least symmetrically distributed between pre-ringing and post-ringing, which is the case at kn = 1, and may be adjusted to be moved to post-ringing only, which is the case at kn = 2.

At step 30, a modified transfer function $C_{mod}(\omega)$ is provided. This is also referred to as a recalculation of $C(\omega)$. In particular, the N expressions (exp(i*kn*$\theta n(\omega)$)), associated with the selected N subsets of poles outside the unit circle, are introduced as additional terms in the denominator of the initial transfer function C(w). Stated in a formulaic manner, the modified transfer function may be written as:

$$C_{mod}(\omega) = \frac{T(\omega)}{H(\omega)\exp(i*k1*\theta 1(\omega))\cdots\exp(i*kn*\theta n(\omega))\cdots\exp(i*kN*\theta N(\omega))}.$$

According to the above formula, the modified transfer function is given in frequency-dependent form. It is pointed out that the modified transfer function may also be given in the z-domain or in any other suitable format.

In another exemplary embodiment, the respective phase modification components have the form (exp(i* kn * fn(8n(w))). In this case, frequency-dependent functions fn are applied to the subset-specific, frequency-dependent phase responses $\theta n(\omega)$, before they become part of the exponential phase modification terms. In this way, the subset-specific, frequency-dependent phase responses $\theta n(\omega)$ may be clipped, windowed or in another way conditioned, before exerting the phase modifying effect. The conditioning via the frequency-dependent functions fn may allow for a more targeted modification in the frequency domain and/or for a reduction of the complexity of the modified transfer function and/or for achieving other design goals.

At step 32, the modified transfer function is provided in terms of an impulse response representation. Said impulse response representation may form the basis for a finite impulse response (FIR) filter implementation of the modified transfer function. It is also possible that the modified transfer function $C_{mod}(\omega)$ forms the basis for a block-based filter implementation of the digital audio filter in the frequency domain.

Fig. 4 illustrates the effect that a method for configuring a digital audio filter in accordance with an exemplary embodiment of the invention, as for example described with respect to Fig. 3, may have on the poles of an initial transfer function. In Fig. 4, four poles 40, 42, 44, 46 outside of the unit circle 50 are depicted in the z-domain, with the depicted coordinate system having the real part on the x-axis and the imaginary part on the y-axis. The first and second poles 40, 42 are a complex conjugate pole pair and have the coordinates 1.0 ± 0.05 i. The third and fourth poles 44, 46 are a complex conjugate pole pair and have the coordinates 1.001 ± 0.02 i.

The first and second poles 40, 42 and the third and fourth poles 44, 46 are four poles of the initial transfer function that are outside the unit circle 50. These four poles 40, 42, 44, 46 may be all poles outside the unit circle 50 of the initial transfer function. It is also possible that the initial transfer function has more poles outside the unit circle, but that only those four poles outside the unit circle are addressed in terms of controlling their pre-ringing. The initial transfer function may have further poles inside the unit circle and/or zeros inside and/or outside the unit circle. The additional poles inside the unit circle and/or the zeros inside and/or outside the unit circle are not depicted in Fig. 4 for ease of illustration.

According to an exemplary embodiment of the invention, the four poles 40, 42, 44, 46 may be addressed via respective phase modification components, as laid out above with respect to steps 26 and 28 of Fig. 3. In the exemplary illustration of Fig. 4, the first and second poles 40, 42 are selected as a first subset of poles outside the unit circle, and the third and fourth poles 44, 46 are selected as a second subset of poles outside the unit circle. For each of the first and second subsets of poles outside the unit circle, a subset-specific partial transfer function is determined, a subset-specific, frequency-dependent phase response of the subset-specific partial transfer function is determined, and a subset-specific phase modification component is determined. In the exemplary illustration of Fig. 4, the first and second phase modification components are of the form $(\exp(i * k1 * \theta1(\omega))$ and $(\exp(i * k2 * \theta2(w))$. The first and second phase modification components are introduced into the transfer function of the digital audio filter and become part of the modified transfer function of the digital audio filter. Setting k1 and k2 to 1 would move the first pole 40, the second pole 42, the third pole 44, and the fourth pole 46 exactly to or close to the unit circle 50. This is illustrated in Fig. 4 via modified first to fourth poles 40', 42', 44', 46'. Setting k1 and k2 to 2 would move the first pole 40, the second pole 42, the third pole 44, and the fourth pole 46 well within the unit circle 50. This is illustrated in Fig. 4 via first to fourth alternatively modified poles 40", 42", 44", 46". In this way, it is illustrated how kn may be used to control the location of the poles of the transfer function with respect to the unit circle 50 and, thus, to control the amount of pre-ringing in the modified transfer function.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed, but that the invention will include all embodiments falling within the scope of the appended claims.

## Claims

1. Method for configuring a digital audio filter (8), comprising:

    determining the poles of an initial transfer function of the digital audio filter in the z-domain, with the initial transfer function comprising a target function component and a compensation function component;
    selecting at least one subset of the poles (40, 42, 44, 46) of the transfer function that are outside the unit circle;
    for each of the at least one subset of the poles (40, 42, 44, 46) of the transfer function that are outside the unit circle:

       determining a subset-specific partial transfer function,
       determining a subset-specific, frequency-dependent phase response of the subset-specific partial transfer function, and
       determining a subset-specific phase modification component, with the subset-specific phase modification component being dependent on the subset-specific, frequency-dependent phase response of the subset-specific partial transfer function; and

    providing a modified transfer function, comprising the target function component, the compensation function component, and at least one subset-specific phase modification component.

2. Method according to claim 1, wherein each of said at least one subset of the poles (40, 42, 44, 46) outside the unit circle comprises one or two or more poles outside the unit circle.

3. Method according to claim 1 or 2, wherein the subset-specific phase modification component comprises a modification term of the form $\exp(i * kn * fn(\theta n(\omega)))$, wherein $\theta n(\omega)$ is the subset-specific, frequency-dependent phase response, wherein $fn(\theta n(\omega))$ is $\theta n(\omega)$ or a windowed version of $\theta n(\omega)$, wherein kn is a factor allowing for the parametrization of an extent of modification of the transfer function.

4. Method according to claim 3, wherein kn is larger than 0, in particular larger than 0 and smaller or equal to 2, further in particular between 1 and 2.

5. Method according to claim 3 or 4, further comprising:
setting kn on the basis of a user input and/or setting kn on the basis of a configuration file and/or setting kn on the basis of a parametrization function.

6. Method according to any of the preceding claims, wherein the subset-specific phase modification component has a purely phase-modifying effect.

7. Method according to any of the preceding claims, wherein said at least one subset of the poles (40, 42, 44, 46) of the transfer function that are outside the unit circle comprises a plurality of subsets of the poles (40, 42, 44, 46) of the transfer function that are outside the unit circle.

8. Method according to claim 7, wherein, for at least a first subset of the poles (40, 42) that are outside the unit circle and a second subset of the poles (44, 46) that are outside the unit circle, the dependencies of a first phase modification component, associated with the first subset, and a second phase modification component, associated with the second subset, on a first subset-specific, frequency-dependent phase response, associated with the first subset, and a second subset-specific, frequency-dependent phase response, associated with the second subset, differ from each other.

9. Method according to claim 7 or 8, wherein, for the plurality of subsets of the poles (40, 42, 44, 46) of the transfer function that are outside the unit circle, each subset-specific phase modification component comprises a respective modification term of the form $\exp(i * kn * fn(\theta n(\omega)))$, wherein $\theta n(\omega)$ is the respective subset-specific, frequency-dependent phase response, wherein $fn(\theta n(\omega))$ is $\theta n(\omega)$ or a windowed version of $\theta n(\omega)$, wherein kn is a factor allowing for the parametrization of an extent of modification of the transfer function.

10. Method according to claim 9, wherein, for at least two of the plurality of subsets of the poles (40, 42, 44, 46) of the transfer function that are outside the unit circle, the kn differ from each other.

11. Method according to any of the preceding claims, further comprising:
providing an FIR filter implementation in the time domain or a block-based filter implementation in the frequency domain in accordance with the modified transfer function.

12. Vehicle sound system (2), comprising:

a digital audio filter (8) configured in accordance with the method according to any of the preceding claims, wherein the compensation function component represents a compensation for auditory space artefacts of a vehicle interior (16).

13. Method for outputting audio content into a vehicle interior (16) with a vehicle sound system according to claim 12, the method comprising:

filtering a digital audio signal with the digital audio filter (8); and
outputting audio content, based on the filtered digital audio signal, via speakers (12) arranged in the vehicle interior (16).

**Patentansprüche**

1. Verfahren zum Konfigurieren eines digitalen Audiofilters (8), aufweisend:

Bestimmen der Pole einer Anfangsübertragungsfunktion des digitalen Audiofilters im z-Bereich, wobei die Anfangsübertragungsfunktion eine Zielfunktionskomponente und eine Kompensationsfunktionskomponente aufweist;
Auswählen mindestens einer Teilmenge der Pole (40, 42, 44, 46) der Übertragungsfunktion, die außerhalb des Einheitskreises liegen;
für jede der mindestens einen Teilmenge der Pole (40, 42, 44, 46) der Übertragungsfunktion, die außerhalb des Einheitskreises liegen:

Bestimmen einer teilmengenspezifischen partiellen Übertragungsfunktion,
Bestimmen eines teilmengenspezifischen frequenzabhängigen Phasengangs der teilmengenspezifischen partiellen Übertragungsfunktion und
Bestimmen einer teilmengenspezifischen Phasenmodifikationskomponente, wobei die teilmengenspezifische Phasenmodifikationskomponente von dem teilmengenspezifischen frequenzabhängigen Phasengang der teilmengenspezifischen partiellen Übertragungsfunktion abhängt; und

Bereitstellen einer modifizierten Übertragungsfunktion, die die Zielfunktionskomponente, die Kompensationsfunktionskomponente und mindestens eine teilmengenspezifische Phasenmodifikationskomponente aufweist.

2. Verfahren nach Anspruch 1, wobei jede der mindestens einen Teilmenge der Pole (40, 42, 44, 46) außerhalb des Einheitskreises einen oder zwei oder mehr Pole außerhalb des Einheitskreises aufweist.

3. Verfahren nach Anspruch 1 oder 2, wobei die teilmengenspezifische Phasenmodifikationskomponente einen Modifikationsterm der Form $\exp(i * kn * fn(\theta n(\omega)))$ aufweist, wobei $\theta n(\omega)$ der teilmengenspezifische frequenzabhängige Phasengang ist, wobei $fn(\theta n(\omega))$ entweder $\theta n(\omega)$ oder eine gefensterte Version von $\theta n(\omega)$ ist, wobei kn ein Faktor ist, der die Parametrisierung des Ausmaßes der Modifikation der Übertragungsfunktion ermöglicht.

4. Verfahren nach Anspruch 3, wobei kn größer als 0 ist, insbesondere größer als 0 und kleiner oder gleich 2, insbesondere zwischen 1 und 2.

5. Verfahren nach Anspruch 3 oder 4, ferner aufweisend:
Einstellen von kn auf Grundlage einer Benutzereingabe und/oder Einstellen von kn auf Grundlage einer Konfigurationsdatei und/oder Einstellen von kn auf Grundlage einer Parametrisierungsfunktion.

6. Verfahren nach einem der vorhergehenden Ansprüche, wobei die teilmengenspezifische Phasenmodifikationskomponente eine rein phasenmodifizierende Wirkung hat.

7. Verfahren nach einem der vorhergehenden Ansprüche, wobei die mindestens eine Teilmenge der Pole (40, 42, 44, 46) der Übertragungsfunktion, die außerhalb des Einheitskreises liegen, eine Mehrzahl von Teilmengen der Pole (40, 42, 44, 46) der Übertragungsfunktion aufweist, die außerhalb des Einheitskreises liegen.

8. Verfahren nach Anspruch 7, wobei für mindestens eine erste Teilmenge der Pole (40, 42), die außerhalb des Einheitskreises liegen, und eine zweite Teilmenge der Pole (44, 46), die außerhalb des Einheitskreises liegen, die Abhängigkeiten einer der ersten Teilmenge zugeordneten ersten Phasenmodifikationskomponente und einer der zweiten Teilmenge zugeordneten zweiten Phasenmodifikationskomponente von einem der ersten Teilmenge zugeordneten ersten teilmengenspezifischen frequenzabhängigen Phasengang und einem der zweiten Teilmenge zugeordneten zweiten teilmengenspezifischen frequenzabhängigen Phasengang voneinander abweichen.

9. Verfahren nach Anspruch 7 oder 8, wobei für die Mehrzahl von Teilmengen der Pole (40, 42, 44, 46) der Übertragungsfunktion, die außerhalb des Einheitskreises liegen, jede teilmengenspezifische Phasenmodifikationskomponente einen entsprechenden Modifikationsterm der Form $\exp(i * kn * fn(\theta n(\omega)))$ aufweist, wobei $\theta n(\omega)$ der entsprechende teilmengenspezifische frequenzabhängige Phasengang ist, wobei $fn(\theta n(\omega))$ entweder $\theta n(\omega)$ oder eine gefensterte Version von $\theta n(\omega)$ ist, wobei kn ein Faktor ist, der die Parametrisierung des Ausmaßes der Modifikation der Übertragungsfunktion ermöglicht.

10. Verfahren nach Anspruch 9, wobei für mindestens zwei der Mehrzahl von Teilmengen der Pole (40, 42, 44, 46) der Übertragungsfunktion, die außerhalb des Einheitskreises liegen, die kn voneinander abweichen.

11. Verfahren nach einem der vorhergehenden Ansprüche, ferner aufweisend:
Bereitstellen einer FIR-Filterimplementierung im Zeitbereich oder einer blockbasierten Filterimplementierung im Frequenzbereich gemäß der modifizierten Übertragungsfunktion.

12. Fahrzeugtonsystem (2), aufweisend:

ein digitales Audiofilter (8), das gemäß dem Verfahren nach einem der vorhergehenden Ansprüche ausgelegt ist, wobei die Kompensationsfunktionskomponente eine Kompensation für Hörraumartefakte eines Fahrzeuginnenraums (16) darstellt.

13. Verfahren zur Ausgabe von Audioinhalten in einen Fahrzeuginnenraum (16) mit einem Fahrzeugtonsystem nach Anspruch 12, wobei das Verfahren aufweist:

Filtern eines digitalen Audiosignals mit dem digitalen Audiofilter (8); und
Ausgeben von Audioinhalten auf Grundlage des gefilterten digitalen Audiosignals über im Fahrzeuginnenraum (16) angeordnete Lautsprecher (12).

**Revendications**

1. Procédé de configuration d'un filtre audio numérique (8), comprenant les étapes consistant à :

   déterminer les pôles d'une fonction de transfert initiale du filtre audio numérique dans le domaine z, la fonction de transfert initiale comprenant une composante de fonction cible et une composante de fonction de compensation ;
   sélectionner au moins un sous-ensemble des pôles (40, 42, 44, 46) de la fonction de transfert qui sont en dehors du cercle unitaire ;
   pour chacun dudit au moins un sous-ensemble des pôles (40, 42, 44, 46) de la fonction de transfert qui sont en dehors du cercle unitaire :

   déterminer une fonction de transfert partielle spécifique au sous-ensemble,
   déterminer une réponse de phase spécifique au sous-ensemble, dépendant de la fréquence, de la fonction de transfert partielle spécifique au sous-ensemble, et
   déterminer une composante de modification de phase spécifique au sous-ensemble, la composante de modification de phase spécifique au sous-ensemble dépendant de la réponse de phase spécifique au sous-ensemble et dépendant de la fréquence de la fonction de transfert partielle spécifique au sous-ensemble ; et
   fournir une fonction de transfert modifiée, comprenant la composante de la fonction cible, la composante de la fonction de compensation et au moins une composante de modification de phase spécifique au sous-ensemble.

2. Procédé selon la revendication 1, dans lequel chacun desdits au moins un sous-ensemble de pôles (40, 42, 44, 46) situés à l'extérieur du cercle unitaire comprend un ou deux ou plusieurs pôles situés à l'extérieur du cercle unitaire.

3. Procédé selon la revendication 1, dans lequel la composante de modification de phase spécifique au sous-ensemble comprend un terme de modification de la forme exp(i * kn * fn(θn(ω))), où θn(ω) est la réponse de phase spécifique au sous-ensemble, dépendant de la fréquence, où fn(θn(ω)) est θn(ω) ou une version fenêtrée de θn(ω), où kn est un facteur permettant la paramétrisation d'une étendue de la modification de la fonction de transfert.

4. Procédé selon la revendication 3, dans lequel kn est supérieur à 0, en particulier supérieur à 0 et inférieur ou égal à 2, plus particulièrement encore compris entre 1 et 2.

5. Procédé selon la revendication 3 ou 4, comprenant en outre les étapes consistant à :
   régler kn sur la base d'une entrée utilisateur et/ou à régler kn sur la base d'un fichier de configuration et/ou à régler kn sur la base d'une fonction de paramétrage.

6. Procédé selon l'une quelconque des revendications précédentes, dans lequel la composante de modification de phase spécifique au sous-ensemble a un effet purement modificateur de phase.

7. Procédé selon l'une quelconque des revendications précédentes, dans lequel ledit au moins un sous-ensemble des pôles (40, 42, 44, 46) de la fonction de transfert qui sont en dehors du cercle unitaire comprend une pluralité de sous-ensembles des pôles (40, 42, 44, 46) de la fonction de transfert qui sont en dehors du cercle unitaire.

8. Procédé selon la revendication 7, dans lequel, pour au moins un premier sous-ensemble des pôles (40, 42) qui sont en dehors du cercle unitaire et un second sous-ensemble des pôles (44, 46) qui sont en dehors du cercle unitaire, les dépendances d'une première composante de modification de phase, associée au premier sous-ensemble, et d'une seconde composante de modification de phase, associée au second sous-ensemble, sur une première réponse de phase spécifique au sous-ensemble, dépendant de la fréquence, associée au premier sous-ensemble, et sur une seconde réponse de phase spécifique au sous-ensemble, dépendant de la fréquence, associée au second sous-ensemble, diffèrent l'une de l'autre.

9. Procédé selon la revendication 7 ou 8, dans lequel, pour la pluralité de sous-ensembles des pôles (40, 42, 44, 46) de la fonction de transfert qui sont en dehors du cercle unitaire, chaque composante de modification de phase spécifique à un sous-ensemble comprend un terme de modification respectif de la forme exp(i * kn * fn(θn(ω))), où θn(ω) est la réponse de phase spécifique au sous-ensemble, dépendant de la fréquence, où fn(θn(ω)) est θn(ω) ou une version fenêtrée de θn(ω), où kn est un facteur permettant la paramétrisation d'une étendue de la modification de la fonction de transfert.

**10.** Procédé selon la revendication 9, dans lequel, pour au moins deux de la pluralité de sous-ensembles des pôles (40, 42, 44, 46) de la fonction de transfert qui sont en dehors du cercle unitaire, les kn diffèrent l'un de l'autre.

**11.** Procédé selon l'une quelconque des revendications précédentes, comprenant en outre :
fournir une implémentation de filtre RIF dans le domaine temporel ou une implémentation de filtre par blocs dans le domaine fréquentiel conformément à la fonction de transfert modifiée.

**12.** Système de sonorisation de véhicule (2), comprenant :

un filtre audio numérique (8) configuré conformément au procédé selon l'une quelconque des revendications précédentes,
dans lequel la composante de fonction de compensation représente une compensation pour les artefacts de l'espace auditif de l'intérieur d'un véhicule (16).

**13.** Procédé permettant d'émettre un contenu audio dans l'habitacle d'un véhicule (16) au moyen d'un système de sonorisation de véhicule selon la revendication 12, le procédé comprenant les étapes consistant à :
filtrer un signal audio numérique au moyen du filtre audio numérique (8) ; et
émettre un contenu audio, basé sur le signal audio numérique filtré, par l'intermédiaire de haut-parleurs (12) disposés dans l'habitacle du véhicule (16).

# Fig. 1

# Fig. 2

# Fig. 3

Calculate initial transfer function
$C(\omega)=T(\omega)/H(\omega)$ ⎯ 20

Zero/pole model of
complete C ⎯ 22

Find poles
outside unit circle ⎯ 24

Compute phase response
for the identified pole(s) ⎯ 26

Modify target phase ⎯ 28

Recalculate C ⎯ 30

New IR C ⎯ 32

# Fig. 4

**EP 3 985 999 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050175193 A1
- US 20140153744 A1